# EUROPEAN PATENT APPLICATION

(11) **EP 3 352 230 A1**
(43) Date of publication of application: **25.07.2018**
(21) Application number: 16813213.2
(22) Date of filing: 06.05.2016
(51) Int. Cl.: H01L 33/52

(54) **WATERPROOF PACKAGING STRUCTURE AND INTEGRATED MOULDING PROCEDURE THEREFOR**

(30) Priority: 08.09.2015 CN 201510567322
(71) Applicant: Li, Feng, Shenzhen, Guangdong 518000 (CN)
(72) Inventor: Li, Feng, Shenzhen, Guangdong 518000 (CN)
(74) Representative: Lang, Christian
(86) International application number: PCT/CN2016/081274
(87) International publication number: WO 2017/041498

(57) **Abstract**

A packaging structure for a waterproof LED lamp contains: a transparent sheet (10), a grid casing (20), and a sealing ring (30), and a sealant (40). The grid casing (20) includes a grille groove (24) formed on a central portion thereof, a first fixing face (21) exposing on a top of the grid casing (20), a second face (22) formed below the first fixing face (21), and a third fixing face (23) defined below the second fixing face (22) flushing with the grille groove (24). Between the third fixing face (23) and the grille groove (24) is defined a retaining trench (25) configured to retain the sealing ring (30), wherein the sealing ring (30) has a T-shaped cross section. The transparent sheet (10) is placed on the sealing ring (30) and the sealant (40), and among the second fixing face (22), the sealing ring (30), and the transparent sheet (10) is defined a gap in which the sealant (40) is fed.

## Description

### FIELD OF THE INVENTION

The present invention relates to a packaging structure, and more particularly to the packaging structure for a waterproof LED lamp which avoids water flowing into the waterproof LED lamp at high water pressure.

### BACKGROUND OF THE INVENTION

A conventional packaging structure is capable of closing a waterproof LED lamp so that the waterproof LED lamp emits lights and avoid water flowing into the waterproof LED lamp.

The waterproof LED lamp has a casing and a printed circuit board (PCB), wherein the casing is fixed by screwing elements, and the casing and the PCB are packaged by way of liquid silicone rubber. Alternatively, a sealing ring mates with a retaining trench defined on the casing so as to close the casing.

However, water flows into the waterproof LED lamp at high water pressure easily.

The present invention has arisen to mitigate and/or obviate the afore-described disadvantages.

### SUMMARY OF THE INVENTION

The primary objective of the present invention is to provide a packaging structure for a waterproof LED lamp which avoids water flowing into the waterproof LED lamp at high water pressure.

To obtain above-mentioned objective, a packaging structure for a waterproof LED lamp provided by the present invention contains: a transparent sheet, a grid casing, and a sealing ring, and a sealant.

The grid casing includes a grille groove formed on a central portion thereof, a first fixing face exposing on a top of the grid casing, a second face formed below the first fixing face, and a third fixing face defined below the second fixing face flushing with the grille groove.

Between the third fixing face and the grille groove is defined a retaining trench configured to retain the sealing ring, wherein the sealing ring has a T-shaped cross section.

The transparent sheet is placed on the sealing ring and the sealant, and among the second fixing face, the sealing ring, and the transparent sheet is defined a gap in which the sealant is fed.

Preferably, the sealing ring includes a support section and a locking section, wherein the support section supports the transparent sheet, and the locking section retains in the retaining trench.

Preferably, the sealant includes a closing portion, a filling portion, and a holding portion forming among the sealing ring, the transparent sheet and the third fixing face. The filing portion is defined among the transparent sheet, the second fixing face, and the third fixing face, and the closing portion forms on the second fixing face and the transparent sheet.

Preferably, a mold is employed to manufacture the waterproof packaging structure and includes a holder and a molding part, wherein the holder and the molding part are configured to position and press the transparent sheet and the grid casing. In a pouring process, the grid casing is placed on the holder in a vacuum condition, wherein the holder houses the grid casing; the sealing ring retains with the retaining trench of the grid casing, and the transparent sheet and the molding part are mounted on the grid casing by automatic equipment; the molding part presses the transparent sheet and the grid casing; the molding part has two apertures defined thereon so as to feed liquid silicone rubber into the mold from the two apertures; the liquid silicone rubber is heated; and the transparent sheet, the grid casing, and the sealing ring are removed from the holder and the molding after the liquid silicone rubber solidifies.

Preferably, a diameter of a lower end of each of the two pouring apertures is 2.0 mm, a diameter of an upper end of said each pouring aperture is more than that of the lower end of said each pouring aperture, a shape of a cross section of said each pouring aperture is in a trumpet shape, and a taper of said each pouring aperture is 5 degrees; the molding part also has two first openings opposite to the two pouring apertures.

Preferably, the molding part is rectangular and has a close end and an open end.

Preferably, the molding part further has two second openings configured to accommodate two heating bars respectively, hence the two heating bars heat the liquid silicone rubber.

Preferably, the transparent sheet has a transparent substrate and an optical transmission film covering on the transparent substrate, wherein the transparent substrate is made of any one of sapphire, acrylic, and optical glass.

### BRIEF DESCRIPTION OF THE DRAWINGS

FIG. 1 is a cross sectional view showing the assembly of a packaging structure for a waterproof LED lamp according to a preferred embodiment of the present invention.
FIG. 2 is an amplified cross sectional view showing a portion A of FIG. 1.
FIG. 3 is a perspective view showing the manufacturing process of the packaging structure according to the preferred embodiment of the present invention.

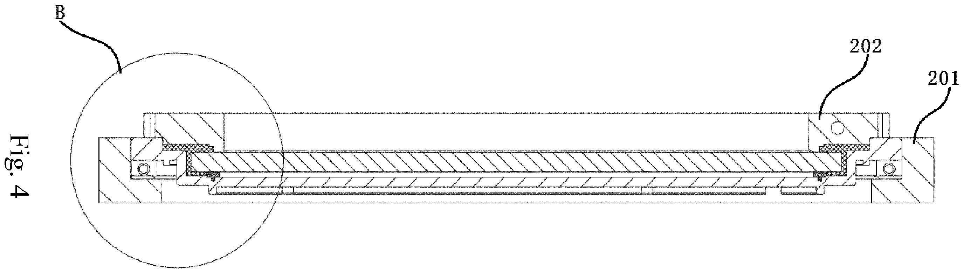

FIG. 4 is a cross sectional view showing the manufacturing process of the packaging structure according to the preferred embodiment of the present invention.

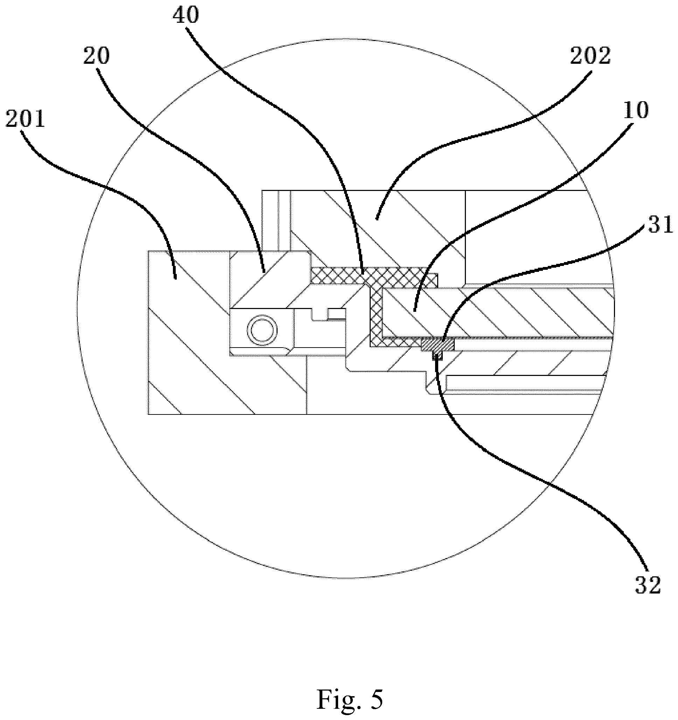

FIG. 5 is an amplified cross sectional view showing a portion B of FIG. 4.

### DETAILED DESCRIPTION OF THE PREFERRED EMBODIMENTS

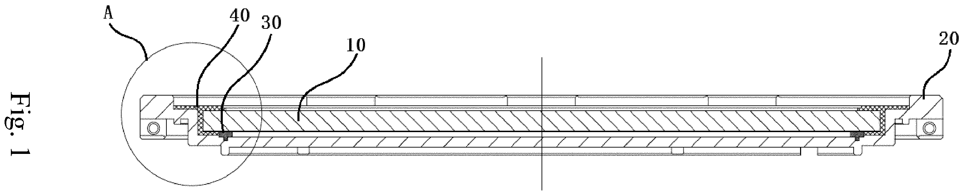

With reference to FIG. 1, a packaging structure for a waterproof LED lamp according to a preferred embodiment of the present invention comprises: a transparent sheet 10, a grid casing 20, and a sealing ring 30. The sealing ring 30 is mounted on the grid casing 20, and the transparent sheet 10 presses the sealing ring 30 and covers on the grid casing 20 under the sealing ring 30, hence among the transparent sheet 10, the sealing ring 30, and the grid casing 20 is defined a closing space in which heat conduction oil is accommodated.

The grid casing 20 includes a grille groove 24 formed on a central portion thereof, a first fixing face 21 exposes on a top of the grid casing 20, a second face 22 formed below the first fixing face 21, and a third fixing face 23 defined below the second fixing face 22, wherein the grille groove 24 partially houses multiple LED chips, and the first fixing face 21, the second fixing face 22, and the third fixing face 23 fix the transparent sheet 10.

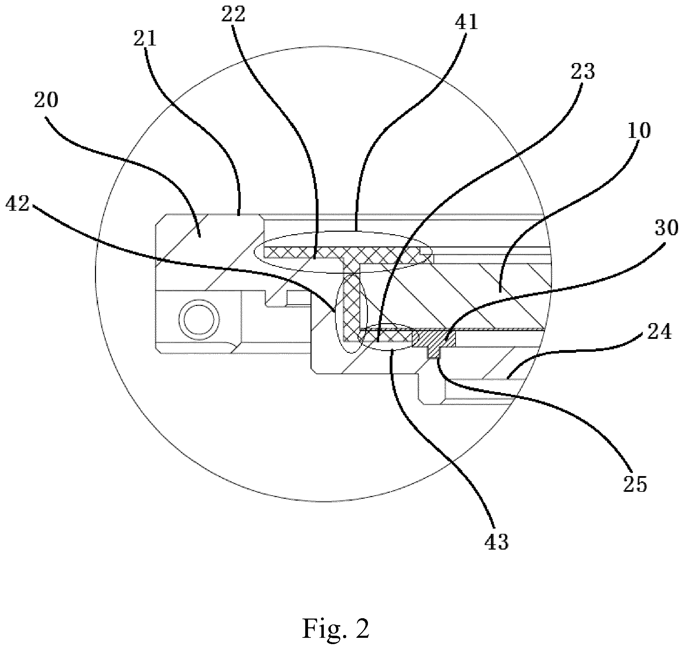

Referring to FIG. 2, the first fixing face 21 is located adjacent to an inner wall of the grid casing 20, a sealant 40 is fed on the second fixing face 22, and the third fixing face 23 flushes with the grille groove 24. Between the third fixing face 23 and the grille groove 24 is defined a retaining trench 25 configured to retain the sealing ring 30, wherein the sealing ring 30 is in a rectangle shape and has a T-shaped cross section.

The sealing ring 30 includes a support section 31 and a locking section 32, wherein the support section 31 supports the transparent sheet 10, and the locking section 32 retains in the retaining trench 25 so as to flush with a holding portion 43 of the sealant 40 on the third fixing face 23, hence the transparent sheet 10 is placed on the locking section 32 and a holding portion 43 of the sealant 40. Among the second fixing face 22, the sealing ring 30, and the transparent sheet 10 is defined a gap in which the sealant 40 is fed.

The sealant 40 includes a closing portion 41, a filling portion 42, and the holding portion 43 forming among the sealing ring 30, the transparent sheet 10, and the third fixing face 23. The filing portion 42 is defined among the transparent sheet 10, the second fixing face 22, and the third fixing face 23. The closing portion 41 forms on the second fixing face 22 and the transparent sheet 10. After the sealant 40 solidifies, it fills the gap among the second fixing face 22, the sealing ring 30, and the transparent sheet 10 so as to adhere the grid casing 20, the transparent sheet 10, and the sealing ring 30 together.

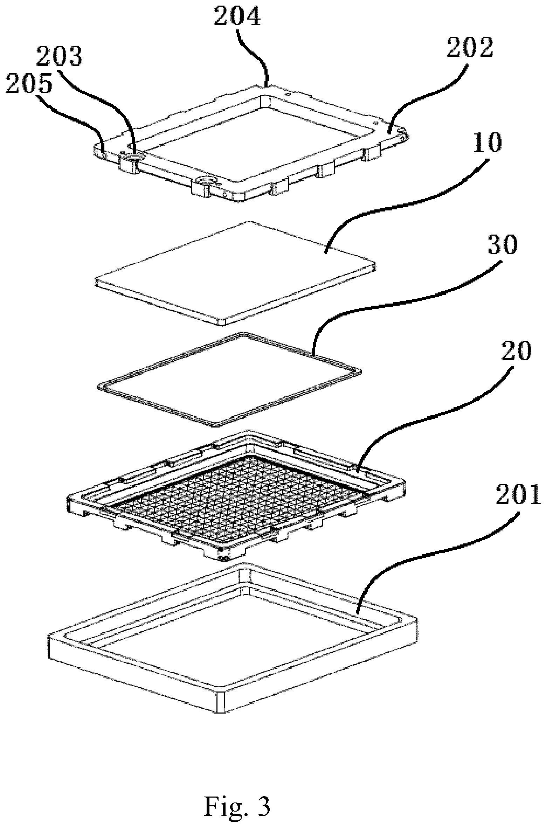

As shown in FIG. 3, a mold is employed to manufacture the waterproof packaging structure and includes a holder 201 and a molding part 202, wherein the holder 201 and the molding part 202 are configured to position and press the transparent sheet 10 and the grid casing 20.

In a pouring process, the grid casing 20 is placed on the holder 201 in a vacuum condition, wherein the holder 201 has an accommodation cavity defined on a bottom thereof so as to house the grid casing 20.

The sealing ring 30 retains with the retaining trench 25 of the grid casing 20, and the transparent sheet 10 and the molding part 202 are mounted on the grid casing 20 by automatic equipment, such that the transparent sheet 10 is located on the sealing ring 30, wherein the third fixing face 23 corresponds to and accommodates the transparent sheet 10.

The molding part 202 has multiple protrusions formed on a peripheral wall thereof and corresponding to multiple recesses on the inner wall of the grid casing 20 respectively, hence the multiple protrusions of the molding part 202 engage with the multiple recesses of the grid casing 20, thus locating the transparent 10 on the sealing ring 30.

The molding part 202 presses the transparent sheet 10 and the grid casing 20, wherein the molding part 202 is rectangular and has a close end and an open end. Alternatively, the molding part 202 has two open ends. It is to be noted that the peripheral wall of the molding part 202 covers on the transparent sheet 10 and the grid casing 20.

The molding part 202 has two apertures 203 defined thereon so as to feed liquid silicone rubber into the mold from the two apertures 203, wherein a diameter of a lower end of each of the two pouring apertures 203 is 2.0 mm, a diameter of an upper end of said each pouring aperture 203 is more than that of the lower end of said each pouring aperture 203, a shape of a cross section of said each pouring aperture 203 is in a trumpet shape, and a taper of said each pouring aperture 203 is 5 degrees. The molding part 202 also has two first openings 204 opposite to the two pouring apertures 203 so that user views if the liquid silicone rubber is full of the mold.

The molding part 202 further has two second openings 205 configured to accommodate two heating bars, respectively, hence the two heating bars heat the liquid silicone rubber after being conducted electricity, thus solidifying the liquid silicone rubber.

The two heating bars heat the sealant 40 at a temperature of 60 °C to 120 °C for 10 minutes, thereafter the transparent sheet 10, the grid casing 20, and the sealing ring 30 are removed from the holder 201 and the molding 202 after the liquid silicone rubber solidifies.

The transparent sheet 10 has a transparent substrate and an optical transmission film covering on the transparent substrate, wherein the transparent substrate is made of any one of sapphire, acrylic, and optical glass.

Thereby, the waterproof packaging structure closes the waterproof LED lamp tightly so as to avoid water flowing into the waterproof LED lamp at high water pressure.

While the preferred embodiments of the invention have been set forth for the purpose of disclosure, modifications of the disclosed embodiments of the invention as well as other embodiments thereof may occur to those skilled in the art. Accordingly, the appended claims are intended to cover all embodiments which do not depart from the spirit and scope of the invention.

## Claims

1. A packaging structure for a waterproof LED lamp comprising: a transparent sheet, a grid casing, and a sealing ring, and a sealant;
the grid casing including a grille groove formed on a central portion thereof, a first fixing face exposing on a top of the grid casing, a second face formed below the first fixing face, and a third fixing face defined below the second fixing face flushing with the grille groove;
wherein between the third fixing face and the grille groove is defined a retaining trench configured to retain the sealing ring, wherein the sealing ring has a T-shaped cross section; and
wherein the transparent sheet is placed on the sealing ring and the sealant, and among the second fixing face, the sealing ring, and the transparent sheet is defined a gap in which the sealant is fed.

2. The packaging structure as claimed in claim 1, wherein the sealing ring includes a support section and a locking section, wherein the support section supports the transparent sheet, and the locking section retains in the retaining trench.

3. The packaging structure as claimed in claim 1, wherein the sealant includes a closing portion, a filling portion, and a holding portion forming among the sealing ring, the transparent sheet and the third fixing face; the filing portion is defined among the transparent sheet, the second fixing face, and the third fixing face; and the closing portion forms on the second fixing face and the transparent sheet.

4. The packaging structure as claimed in claim 2, wherein a mold is employed to manufacture the waterproof packaging structure and includes a holder and a molding part, wherein the holder and the molding part are configured to position and press the transparent sheet and the grid casing; in a pouring process, the grid casing is placed on the holder in a vacuum condition, wherein the holder houses the grid casing; the sealing ring retains with the retaining trench of the grid casing, and the transparent sheet and the molding part are mounted on the grid casing by automatic equipment; the molding part presses the transparent sheet and the grid casing; the molding part has two apertures defined thereon so as to feed liquid silicone rubber into the mold from the two apertures; the liquid silicone rubber is heated; and the transparent sheet, the grid casing, and the sealing ring are removed from the holder and the molding after the liquid silicone rubber solidifies.

5. The packaging structure as claimed in claim 4, wherein a diameter of a lower end of each of the two pouring apertures is 2.0 mm, a diameter of an upper end of said each pouring aperture is more than that of the lower end of said each pouring aperture, a shape of a cross section of said each pouring aperture is in a trumpet shape, and a taper of said each pouring aperture is 5 degrees; the molding part also has two first openings opposite to the two pouring apertures.

6. The packaging structure as claimed in claim 5, wherein the molding part is rectangular and has a close end and an open end.

7. The packaging structure as claimed in claim 4-6, wherein the molding part further has two second openings configured to accommodate two heating bars, respectively, hence the two heating bars heat the liquid silicone rubber.

8. The packaging structure as claimed in claim 4, wherein the transparent sheet has a transparent substrate and an optical transmission film covering on the transparent substrate, wherein the transparent substrate is made of any one of sapphire, acrylic, and optical glass.
